Europäisches Patentamt

European Patent Office

Office européen des brevets

(11) Veröffentlichungsnummer: **0 076 962**
A1

# EUROPÄISCHE PATENTANMELDUNG

(21) Anmeldenummer: 82108916.6

(22) Anmeldetag: 27.09.82

(51) Int. Cl.³: **H 03 K 17/60**

(30) Priorität: 09.10.81 DE 3140187

(43) Veröffentlichungstag der Anmeldung: 20.04.83
Patentblatt 83/16

(84) Benannte Vertragsstaaten: **AT BE CH FR GB IT LI NL SE**

(71) Anmelder: **BROWN, BOVERI & CIE Aktiengesellschaft,
Kallstadter Strasse 1, D-6800 Mannheim 31 (DE)**

(72) Erfinder: **Küber, Mathias, Karlsruher Strasse 76,
D-6834 Ketsch (DE)**
Erfinder: **Müller, Hans-Richard, Hauptstrasse 36a,
D-6901 Eppelheim (DE)**

(74) Vertreter: **Kempe, Wolfgang, Dr. et al, c/o Brown, Boveri
& Cie AG Postfach 351, D-6800 Mannheim 1 (DE)**

(54) Schaltungsanordnung zur Ansteuerung von Leistungstransistoren.

(57) Ein Leistungstransistor (V2) wird fortwährend durchgeschaltet, in dem einmal eine durch einen Taktimpuls hervorgerufene Durchschaltung der Vorstufen (UND-Glied 1 und
Vortransistor V1) und einmal die in einer Induktivität (S1)
gespeicherte Energie ausgenutzt werden. Da der Leistungstransistor (V2) immer durchgeschaltet ist, und eine Verlustleistung im wesentlichen nur während der Zeit der Taktimpulse auftritt, kann die Anordnung wärmetechnisch (hohe
Packungsdichte) sehr einfach aufgebaut werden.

EP 0 076 962 A1

0076962

BROWN, BOVERI & CIE   AKTIENGESELLSCHAFT
Mannheim                           6. Okt. 1981
Mp.-Nr. 657/81                     ZPT/P3-NL/Bt

Schaltungsanordnung zur Ansteuerung von Leistungstransistoren

Die Erfindung bezieht sich auf eine Schaltungsanordnung
zur Ansteuerung von Leistungstransistoren mit geringer
Verlustleistung, bestehend aus einem Vorstufentransistor
und einem Leistungstransistor sowie den erforderlichen
Basis- und Ableitwiderständen und einer Versorgungsspannungsquelle. Die Anordnung findet vorwiegend Anwendung
bei elektronischen Steuerungen.

Bekannte Schaltungen zur Erzeugung eines erforderlichen
Strom- oder Spannungspegels bestehen meistens aus der
Kombination eines Vorstufentransistors und eines Leistungstransistors. Dabei wird der Vorstufentransistor
zur Verstärkung verwendet, um den nachfolgenden Leistungstransistor leistungsmäßig anzusteuern. Derartige
Schaltungen sind allgemein bekannt (BBC-Broschüre:
System für industrielle Steuerungen). Aufgrund der
geringen Stromverstärkung des Leistungstransistors wird
ein hoher Basisstrom benötigt, der am Basiswiderstand
eine große Ansteuerverlustleistung erzeugt. Diese große

Mp.-Nr. 657/81                    2

Verlustleistung muß als Wärme abgeführt werden.

Zur Vermeidung hoher Ansteuerverlustleistungen ist es bekannt, als Leistungsstufe Darlington-Transistoren zu verwenden. Diese bestehen aus der Zusammenschaltung zweier Transistoren, so daß das Produkt der Stromverstärkung von beiden Transistoren ausgenutzt werden kann. Dadurch kann zwar die Ansteuerverlustleistung verringert werden, es treten aber durch die Verwendung eines Darlington-Transistors größere Sättigungsverluste auf.

Es ist deshalb Aufgabe der Erfindung, eine Schaltungsanordnung zu finden, die einerseits die geringen Sättigungsverluste nur eines Transistors und andererseits die geringe Ansteuerverlustleistung einer Darlington-Endstufe aufweist.

Erfindungsgemäß wird dies dadurch erzielt, daß der Ausgang eines taktmäßig angesteuerten UND-Gliedes über Widerstände auf die Basis eines NPN-Transistors geführt ist, daß der Kollektor des NPN-Transistors einmal über eine Diode in Sperrichtung an die Versorgungsspannungsquelle und einmal über eine Spule und einen Widerstand auf die Basis eines PNP-Transistors gelegt ist, daß der Emitter des NPN-Transistors auf Minus-Potential geführt ist und daß der Emitter des PNP-Transistors an Plus-Potential liegt und der Kollektor den Leistungsausgang bildet. In einer vorteilhaften Ausgestaltung ist parallel zum Basisvorwiderstand des PNP-Transistors ein Komparator angeschaltet, der einen Schmitt-Trigger mit negiertem Ausgang ansteuert, der wiederum auf den Takteingang des UND-Gliedes gelegt ist.

Vorteilhaft bei der erfindungsgemäßen Schaltungsanordnung ist besonders die Verwendung nur eines einfachen Leistungstransistors. Durch die getaktete Ansteuerung der Anordnung kann zudem die Ansteuerverlustleistung sehr gering gehalten werden, was erhebliche Vorteile bei der Packungsdichte mit sich bringt. Denn durch die jetzt reduzierte Wärmeabgabe können die Bauteile kleiner bemessen werden, sie können enger zusammengebaut werden und eventuelle zusätzliche Wärmeabfuhreinrichtungen, wie Kühlbleche oder Lüfter, werden entbehrlich.

Weitere Vorteile sind aus der nachfolgenden Beschreibung ersichtlich.

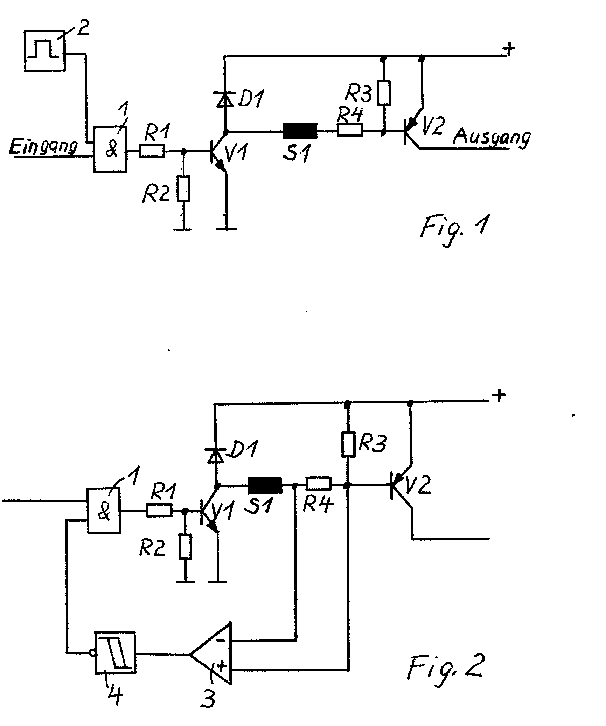

Ein Ausführungsbeispiel der erfindungsgemäßen Schaltungsan ordnung wird nachstehend anhand der Zeichnungen näher erläutert. Dieses in Fig. 1 gezeigte Ausführungsbeispiel mit freischwingendem Oszillator kann gemäß Fig. 2 durch eine Schaltung mit selbstschwingendem Oszillator ergänzt werden.

Zur Verstärkung digitaler Gleichspannungssignale ist auf ein UND-Glied 1 ein digitales Freigabesignal geringen Pegels geführt. Auf den anderen Eingang des UND-Gliedes 1 werden die Impulse eines Taktoszillators 2 gelegt. Dabei ist das UND-Glied immer dann durchgeschaltet, wenn das Freigabesignal "1"-Potential und das Taktsignal auch "1"-Potential aufweist. In einem derartigen Fall wird die Basis eines nachgeschalten NPN-Transistors V1 über Widerstände (Basisableitwiderstand R2 und Basisvorwiderstand R1) durch das Freigabesignal angesteuert. Der Transistor V1, der vorher in Ruhestellung war, erhält einen Impuls durch das Freigabesignal und schaltet durch. Dieses Durchschalten bewirkt einen Stromfluß von der Versorungsspannungsquelle (Plus-Potential) über die Emitter-Basis-Strecke eines PNP-Leistungstransistors V2, über die Reihenschaltung eines Basisvorwiderstandes R4 und einer Spule S1, sowie über die Kollektor-Emitter-Strecke des Transistors V1 nach Minus-Potential.

Das Durchschalten von Transistor V2 erfolgt dadurch, daß nach dem Durchschalten von Transistor V1 Minus-Potential über die Emitter-Kollektor-Strecke, die Spule S1 und den Widerstand R4 auch an der Basis von Transistor V2 anliegt. Da dadurch die Schaltbedingung für einen PNP-Transistor (Emitterspannung mindestens 0,7V höher als Basisspannung) erfüllt ist, schaltet der Transistor V2 durch und gibt einen Leistungsausgang am Kollektor von Transistor V2 frei. Der Widerstand R3 zwischen Basis und Emitter von V2 dient nur als Basisableitwiderstand.

Der durchgeschaltete Zustand der beiden Transistoren V1 und V2 hält so lange an, wie das UND-Glied 1 am Ausgang logisch Eins aufweist (also durchgeschaltet ist). Nach einer gewissen Zeit geht das im Taktoszillator 2 erzeugte Taktsignal auf Null-Potential und sperrt das UND-Glied 1. Gleichzeitig wird dadurch auch der Vorstufentransistor V1 gesperrt. Jetzt ist der bisherige Stromfluß vom Plus-Potential über die Transistoren V1 und V2 nach Minus-Potential unterbrochen. Die im bisherigen Stromfluß angeordnete Induktivität der Spule S1 hat die physikalische Eigenschaft, für eine gewisse Zeit den Stromfluß aufrechtzuhalten (als treibende Spannungsquelle). Es setzt deshalb ein Stromfluß ein über eine Freilaufdiode D1, die vom Kollektor von V1 zum Emitter von V2 bzw. zur Spannungsversorgungsquelle geschaltet ist. Dieser Stromfluß von der Spule S1 über die Diode D1, über die Emitter-Basis-Strecke von V2 und den Widerstand R4 läßt den Leistungsausgang von Transistor V2 weiter durchgeschaltet. Dieser durchgeschaltete Zustand ist natürlich nur so lange gegeben, wie die Spule S1 durch die gespeicherte magnetische Energie den

Mp.-Nr. 657/81      5      0076962

Stromfluß aufrecht halten kann. Diese Zeit läßt sich durch Ändern der Induktivität der Spule einstellen.

Im nächsten Augenblick geht das Taktsignal des Oszillators 2 wieder auf "1"-Potential, das UND-Glied 1 ist durchgeschaltet, Transistor V1 ist durchgeschaltet und Transistor V2 bleibt durchgeschaltet. Allerdings jetzt von Plus-Potential über seine Emitter-Basis-Strecke, den Widerstand R4, Spule S1 und Kollektor-Emitter von V1 nach Minus-Potential.

Der Leistungstransistor V2 bleibt also fortwährend durchgesteuert. Einmal wird er über die Induktivität der Spule S1 als treibende Spannungsquelle leitend und, wenn die magnetische Energie der Spule nachläßt, wird über einen neuen Taktimpuls vom Oszillator 2 der Stromfluß durch den Transistor V2 fortgesetzt. Es wird dadurch in vorteilhafter Weise erreicht, daß nur während der Zeit der Taktimpulse die gesamte Anordnung angesteuert wird (und damit Verlustleistung erzeugt wird). In der Zeit zwischen den Taktimpulsen fällt nur eine Verlustleistung an, der Leistungstransistor V2 ist aber trotzdem durchgesteuert.

Durch Einstellen der Frequenz des Taktoszillators 2 und der Induktivität der Spule S1 läßt sich der Transistor V2 in der Sättigung halten. Um diesen Vorgang der zeitlichen Justierung zwischen Oszillator 2 und Spule S1 zu automatisieren, wird in einer vorteilhaften Ausgestaltung der erfindungsgemäßen Anordnung nach Fig. 2 der Spannungsabfall über den Basisvorwiderstand R4 abgegriffen und auf einen Komparator 3 geführt. Dieser Komparator ist beispielsweise als Operationsverstärker ausgebildet. Der Zustand des Leistungsverstärkers V2 wird also durch den Komparator 3 abgefragt und in einem nachfolgenden Schmitt-Trigger 4 ausgewertet. Sobald der Spannungsabfall über den Widerstand R4 einen bestimmten Wert erreicht hat, wird der Schmitt-Trigger durchgeschaltet und gibt sein invertiertes Signal auf das nachgeschaltete UND-Glied 1. (Es wurden dieselben Bezeichnungen wie in Fig. 1 gewählt). Dadurch wird das UND-Glied 1 und der Transistor V1 gesperrt. Jetzt tritt die magnetische Energie aus der Spule S1 in Aktion. Damit sinkt auch gleichzeitig der Spannungsabfall am Widerstand R4 und der Komparator bzw. der Schmitt-Trigger 4 kommt an seinen unteren Umschaltpunkt. Der Schmitt-Trigger 4 schaltet wieder um und legt "1"-Potential an das UND-Glied 1. Damit ist die gesamte Anordnung wieder im durchgeschalteten Zustand. Durch einen definierten Takt, der nur durch den Spannugnsabfall am Widerstand R4 abgeleitet ist und damit unabhängig von Bauteil- und Spannungstoleranzen ist, werden also das UND-Glied 1 und der Transistor V1 zu- und abgeschaltet.

Die erfindungsgemäße Anordnung arbeitet also kurz zusammengefaßt so, daß der Basisstrom für den PNP-Transistor V2 einmal - während der Zeit, in der der Ausgang des UND-Gliedes 1 logisch Eins-Signal aufweist - über die Reihenschaltung aus Spule S1, Widerstand R4 und die Kollektor-Emitter-Strecke von V1 nach "0"-Potential fließt, und einmal - während der Zeit, in der der Ausgang des UND-Gliedes 1 logisch Null-Signal aufweist - bedingt durch die Spule S1 als treibende Spannungsquelle über die Reihenschaltung aus Spule S1, Widerstand R4 und die Freilaufdiode D1 fließt.

Ansprüche

1. Schaltungsanordnung zur Ansteuerung von Leistungstransistoren mit geringer Verlustleistung, bestehend aus einem Vorstufentransistor und einem Leistungstransistor sowie den erforderlichen Basis- und Ableitwiderständen und einer Versorgungsspannungsquelle, dadurch gekennzeichnet, daß der Ausgang eines taktmäßig angesteuerten UND-Gliedes (1) über Widerstände (R1,R2) auf die Basis eines NPN-Transistors (V1) geführt ist, daß der Kollektor des NPN-Transistors (1) einmal über eine Diode (D1) in Sperrichtung an die Versorgungsspannungsquelle und einmal über eine Spule (S1) und einen Widerstand (R4) auf die Basis eines PNP-Transistors (V2) gelegt ist, daß der Emitter des NPN-Transistors (V1) auf Minus-Potential geführt ist und daß der Emitter des PNP-Transistors (V2) an Plus-Potential liegt und der Kollektor den Leistungsausgang bildet.

2. Schaltungsanordnung nach Anspruch 1, dadurch gekennzeichnet, daß parallel zum Widerstand (R4) ein Komparator (3) angeschaltet ist, der einen Schmitt-Trigger (4) mit negiertem Ausgang ansteuert, der wiederum auf den Takteingang des UND-Gliedes (1) gelegt ist.

0076962

Fig. 1

Fig. 2

Europäisches
Patentamt

**EUROPÄISCHER RECHERCHENBERICHT**

0076962

Nummer der Anmeldung

EP 82 10 8916

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| | --- | | H 03 K 17/60 |
| X | FR-A-2 418 577 (R.T.C. LA RADIOTECHNIQUE-COMPELEC) * Seite 3, Zeile 37 bis Seite 5, Zeile 16; Figuren 1 und 2 * | 1,2 | |
| | --- | | |
| A | DE-A-2 504 823 (SIEMENS) * Seite 4, erster Absatz; Figur 1 * | 1,2 | |
| | --- | | |
| A | ELEKTROTECHNIK, Band 56, Nr. 22, 21. November 1974, Würzburg (DE) A.F. SCHAFFERNAK: "Zur Problematik kontaktloser Niederspan", Seiten 10-14. * Seite 11, Figur 2 * | 1 | |
| | ----- | | |

RECHERCHIERTE SACHGEBIETE (Int. Cl. ³)

H 03 K

Der vorliegende Recherchenbericht wurde für alle Patentansprüche erstellt.

| Recherchenort | Abschlußdatum der Recherche | Prüfer |
|---|---|---|
| DEN HAAG | 13-01-1983 | CANTARELLI R.J.H. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument
& : Mitglied der gleichen Patentfamilie, übereinstimmendes Dokument

EPA Form 1503. 03.82